(19) Europäisches Patentamt / European Patent Office / Office européen des brevets

(11) **EP 3 796 404 B1**

(12) **EUROPEAN PATENT SPECIFICATION**

(45) Date of publication and mention
of the grant of the patent:
**01.12.2021 Bulletin 2021/48**

(51) Int Cl.:
***H01L 35/16*** *(2006.01)*    ***H01L 35/32*** *(2006.01)*

(21) Application number: **19198306.3**

(22) Date of filing: **19.09.2019**

(54) **AG-SE-BASED N-TYPE THERMOELECTRIC MATERIAL AND FLEXIBLE PRINTED THERMOELECTRIC GENERATOR COMPRISING THE SAME**

AG-SE-BASIERTES THERMOELEKTRISCHES MATERIAL VOM N-TYP UND FLEXIBLER GEDRUCKTER THERMOELEKTRISCHER GENERATOR DAMIT

MATÉRIAU THERMOÉLECTRIQUE DE TYPE N BASÉ SUR AG-SE ET GÉNÉRATEUR THERMOÉLECTRIQUE IMPRIMÉ SOUPLE LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**24.03.2021 Bulletin 2021/12**

(73) Proprietor: **Karlsruher Institut für Technologie 76131 Karlsruhe (DE)**

(72) Inventors:
• **Mallick, Mofasser**
**76297 Stutensee (DE)**
• **Lemmer, Ulrich**
**76228 Durlach (DE)**
• **Rösch, Andres**
**76227 Karlsruhe (DE)**
• **Franke, Leonard**
**76131 Karlsruhe (DE)**

(74) Representative: **Müller-Boré & Partner Patentanwälte PartG mbB Friedenheimer Brücke 21 80639 München (DE)**

(56) References cited:
**CN-A- 109 585 638    US-A1- 2013 142 963**

• YUFEI DING ET AL: "High performance n-type Ag2Se film on nylon membrane for flexible thermoelectric power generator", NATURE COMMUNICATIONS, vol. 10, no. 1, 19 February 2019 (2019-02-19), XP055661166, DOI: 10.1038/s41467-019-08835-5
• YAO LU ET AL: "Ultrahigh power factor and flexible silver selenide-based composite film for thermoelectric devices", ENERGY ENVIRON. SCI, 1 July 2019 (2019-07-01), XP055661411, DOI: 10.1039/c9ee01609k
• JAIME ANDRES PEREZ-TABORDA ET AL: "High Thermoelectric zT in n-Type Silver Selenide films at Room Temperature", ADVANCED ENERGY MATERIALS, vol. 8, no. 8, 5 December 2017 (2017-12-05), page 1702024, XP055660834, DE ISSN: 1614-6832, DOI: 10.1002/aenm.201702024

**Description**

The present invention relates to a flexible printed Ag-Se-based n-type thermoelectric material obtainable by printing an Ag-Se-based ink composition comprising a mixture of Ag and Se powders, as well as to a flexible printed high power density thermoelectric generator comprising the flexible printed Ag-Se-based n-type thermoelectric material and its use, particularly for large scale applications. Further, the present invention also relates to a method for producing the flexible printed Ag-Se-based n-type thermoelectric material.

The technical field of the present invention generally relates to printable thermoelectric materials particularly for large scale applications. Thermoelectric (TE) is a simple energy harvesting technology with no moving components. Currently, approximately 65 % of used energy is being wasted as heat, hence harvesting electrical energy from waste heat via thermoelectric generators (TEGs) can be a promising renewable energy harvesting technology. Despite of being a promising energy conversion technology, TEGs are yet to be employed to a large extent for real life applications. Even after several decades of extensive research on TE materials, it has not fulfilled the long-standing promise of broad applicability and is not in a position to compete with other energy conversion technologies such as photovoltaics. So far, a large variety of conventional bulk n- or p-type TE materials, ranging from chalcogenides, Si-Ge to skutterudite and half-heusler alloys have been studied and developed. Among them, only widely known $Bi_2Te_3$-based materials are successfully implemented for TE device applications at ambient temperature.

Up to now, the research on TE materials has been focusing on improving the figure-of-merit of TE materials, i.e. the thermoelectric figure-of-merit defined as $zT = (S^2\sigma/\kappa)\cdot T$, where S represents the Seebeck coefficient, $\sigma$ represents the electrical conductivity, $\kappa$ represents the thermal conductivity, and T represents the absolute temperature. Higher zT values indicate an excellent performance of the TE material. However, it has been apprehended that production of low cost and high output power density TE devices using conventional bulk materials are still a significant challenge due to a large amount of material used and complex manufacturing processes, hence fabrication has been expensive and challenging. Furthermore, the TE devices made of bulk materials are not flexible and not easy to be integrated in non-flat surfaces of different micro and complex electronic or mechanical systems, and thus their applications are limited.

2D printable high efficiency TE materials could be employed to counter the drawbacks associated with the conventional inorganic-based bulk TEGs. However, printable materials with adequately high TE performance are hard to be found. Even if the inorganic based TE materials are made printable, the TE transport parameters are affected during ink processing, particularly the electrical conductivity ($\sigma$), resulting in low performance.

Recently, flexible 2D printed (such as screen printing, inkjet printing and doctor blading) functional materials have shown a great potential to be used in manufacturing low cost, high yield and high-density multifunctional devices. Therefore, development of efficient flexible 2D printed TE materials could reduce the production costs significantly and could also allow wider applications. Because of poor printability or low TE performance after printing of inorganic-based bulk state-of-the-art TE materials, attention has been given to conductive polymers as a potential candidate for printable TE materials due to their good printability, environmental stability, high electrical conductivity ($\sigma$) and low thermal conductivity ($\kappa$). However, they usually exhibit very low Seebeck coefficients (S), hence low TE performance. Recently, it has been reported that some printable conductive polymers, such as p-type PEDOT:PSS [poly(3,4-ethylenedioxythiophene) polystyrene sulfonate], can have a high thermoelectric figure-of-merit of 0.42 at room temperature (RT) mainly due to high $\sigma$ where S is still low as described by G.H. Kim et al., Nat. Mater., 2013, 12, 719-723. Still, PEDOT:PSS-based polymers even with a zT < 0.4 have not been reproduced or reported so far. Currently, efforts are still being made to enhance TE performance of conductive polymers, such as p-type PEDOT and n-type 1,1,2,2-ethenetetrathiolate(ett)-metal coordination polymers [poly[$A_x$(M-ett)] (A = Na, or K; M = Ni, or Cu)], through hybridization and functionalization with different inorganic or organic elements and compounds.

Even though some good organic-based printable p-type TE materials have been reported e.g. in EP 3 477 718 A1, so far, no sufficiently efficient and environmentally stable n-type printable TE material has been reported for device fabrication due to either low Seebeck coefficients, poor printability and environmental instability. Consequently, research on high efficiency inorganic bulk TE materials has been going on to make them printable while preserving their bulk properties. However, in printed materials based on conventional inorganic bulk TE materials, binder, solvent and additives heavily interrupt the TE transport parameters at grain boundaries, particularly the electrical conductivity $\sigma$, resulting in low performance.

$Bi_2Te_3$-based n-and p-type materials are known to be good TE materials for room temperature (RT) applications, but poor printability and environmental instability limit their use in printing technologies. US 2019/002711 A1 discloses a TE ink for TE materials, which comprises an inorganic binder and $Bi_2Te_3$-based TE particles, wherein the inorganic binder comprises a chalcogenidometallate (ChaM), such as $Sb_2Te_3$, wherein the inorganic binder is included in an amount of 1 to 50 parts by weight based on 100 parts by weight of the TE particles. Said ink is described to be suitable to provide a 3D printed TE material. 3D printing technology is deemed to solve curvature related problems of non-flat surfaces and different shapes. However, even though there are some reports on printed $Bi_2Te_3$-based TE materials, their performances are found to be much lower compared to that of their bulk form.

Recently, the n-type organic intercalated $TiS_2$ has been reported to be a flexible TE material with a power factor ($S^2\sigma$) value of 450 $\mu Wm^{-1}K^{-2}$, but it is still a challenge to make them printable and also the material is found to be very unstable in open atmosphere (cf. Nature Materials, Volume 14, pages 622-627 (2015)).

YUFEI DING ET AL: "High performance n-type Ag2Se film on nylon membrane for flexible thermoelectric power generator",NATURE COMMUNICATIONS, vol. 10, no. 1, 19 February 2019 (2019-02-19), XP055661166 describes a n-type thermoelectric Ag-Se based film. CN109585638 A discloses n-type Ag2Q (Q= S, Se or Te) as a bulk powder thermoelectric material. The Ag and Se powder was weighed in a molar ratio of 2:1 (corresponding to the stoichiometric formula Ag2Te). The powder is made into conventional pellets for forming a conventional TE device.

Hence, it has been a substantial challenge to develop an environmentally stable inorganic-based printed material with high TE performance.

Based on the above, the object of the invention is to provide an environmentally stable and printable inorganic based n-type TE material which should have an improved TE performance, and which should be capable to reproducibly and efficiently provide high power density, yet low cost TEGs.

According to the present invention, the above object is achieved by providing an Ag-Se-based ink composition for n-type printable thermoelectric materials as characterized in claim 1. The above object is also achieved by a method for producing a flexible printed Ag-Se-based n-type thermoelectric material as characterized in claim 8. In addition, the above object is achieved by a flexible printed Ag-Se-based n-type thermoelectric material as characterized in claim 11. Furthermore, the above object is achieved by providing a flexible printed thermoelectric generator as characterized in claim 13 as well as its use as characterized in claim 15. Preferred embodiments of the present invention are set out in the dependent claims.

The present invention is based on a new strategy for producing a flexible printed Ag-Se-based n-type thermoelectric material comprising a binary $Ag_2Se$ phase, which is based on a moderate temperature post printing sintering procedure in order to avoid detrimental effects at grain boundaries preserving its high TE performance. Therefore, unlike conventional inorganic powder based printed films containing grain boundaries, interruption of carrier transportation through the percolated path of the $Ag_2Se$ phase has been minimized in the present invention, which results in high advantageous electrical conductivity $\sigma$, and thus in an improved TE performance.

Specifically, the present invention provides an Ag-Se-based ink composition for n-type printable thermoelectric materials, comprising a mixture of Ag and Se powders, and a thermoplastic resin as organic binder dissolved in an organic solvent, wherein the weight ratio of the Ag powder to the Se powder expressed by the formula (1-x)Ag : xSe is in the range of $0.20 < x \leq 0.80$.

Preferably, the thermoplastic resin is selected from polystyrene and polystyrene copolymers.

According to the present invention, the solvent is preferably selected from the group consisting of toluene, ethylbenzene, chlorobenzene, N,N-dimethylformamide, cyclohexanol, cyclohexanone and mixtures thereof.

Preferably, in the Ag-Se-based ink composition, the weight ratio of the Ag and Se powders to the total weight of the thermoplastic resin and the organic solvent is in the range of 0.5:1 to 2.5:1.

The Ag-Se-based ink composition according to the present invention may further comprise at least one additive selected from siliceous or siliceous and aluminous materials, preferably silica fume.

The particle size of the Ag powder used in the ink composition is preferably 10.0 $\mu$m or less, whereas the particle size of the Se powder is preferably 150 $\mu$m or less.

In addition, the present invention provides a method for producing a flexible printed Ag-Se-based n-type thermoelectric material. The method comprises the steps of:

- providing the Ag-Se-based ink composition according to the present invention;
- printing the Ag-Se-based ink composition onto a substrate; and
- sintering the Ag-Se-based ink composition at a temperature of 160°C to 350°C.

Preferably, the step of sintering is carried out for at least 60 seconds.

The step of printing the Ag-Se-based ink composition onto the substrate is preferably carried out by at least one selected from the group consisting of screen printing, doctor blading, airbrushing and inkjet printing.

In a further aspect, the present invention provides a flexible printed Ag-Se-based n-type thermoelectric (TE) material obtainable by printing the Ag-Se-based ink composition according to the present invention onto a substrate and sintering the Ag-Se-based ink composition at a temperature of 160°C to 350°C, wherein the n-type printed TE material comprises a binary $Ag_2Se$ phase.

The flexible printed Ag-Se-based n-type thermoelectric material preferably has a thickness of 10 to 100 $\mu$m.

The present invention further provides a flexible printed thermoelectric generator (f-TEG) comprising said flexible printed Ag-Se-based n-type thermoelectric material as n-type legs.

According to a preferred embodiment, the flexible printed TEG further comprises p-type legs made of a printable conductive polymer selected from p-doped poly(3,4-ethylenedioxy-thiophene)-based polymers (PEDOT-based polymers).

Said flexible printed TEG can be used in waste heat recovery applications, or in cooling applications integrated with wearable materials to maintain or lower a body temperature.

According to the present invention, high performance Ag-Se-based n-type printed TE materials have been developed through a new and fast synthesis approach, which is based on a moderate temperature post printing sintering procedure in order to avoid detrimental effects at grain boundaries preserving its high TE performance. In particular, the present invention provides a very easy and fast method of producing n-type printable TE materials, which does not involve any rigorous process step. The Ag-Se-based ink composition of the present invention is stable for several months and provides similar performance over an extended period. The resulting flexible printed Ag-Se-based n-type TE materials have surprisingly a very high TE power factor and zT at room temperature. Using the TE material of the present invention for n-type legs, a flexible TE generator (f-TEG) can be manufactured showing a very high maximum output power density. Notably, the printed Ag-Se-based n-type TE materials can be produced repeatably and are stable even in air attributing their potential in industrial applications.

The present invention including preferred embodiments will now be described in more detail along with the accompanying figures. The figures show:

Fig. 1: Temperature dependent X-ray pattern obtained from a printed film of 0.3Ag-0.7Se.

Fig. 2: SEM micrographs of (a) the as prepared, (b) partially reacted, and (c) fully reacted 0.3Ag-0.7Se printed films obtained in Example 1.

Fig. 3: Elemental mapping of Se for (a) the as prepared and that of the fully reacted film of (b) Se phase, (c) Ag phase, and (d) $Ag_2Se$ phase obtained in Example 1.

Fig. 4: (a) Variation of TE parameters $\sigma$, S, and $S^2\sigma$ (power factor) depending on the amount of Se (x) in (1-x)Ag-(x)Se (y-intercept on the left hand side relates to the Seebeck coefficient S, left y-intercept on the right hand side relates to the electrical conductivity $\sigma$, and right y-intercept on the right hand side relates to the power factor $S^2\sigma$); (b) variation of $\sigma$, (c) S, and (d) $S^2\sigma$ with different sintering times at different temperatures (160°C, 180°C and 300°C).

Fig. 5: Variation of TE parameters $\sigma$, S, and $S^2\sigma$ (power factor) depending on the sintering time for printed 0.3Ag-0.7Se films containing polystyrene-based Ag paste (Example 4) (y-intercept on the left hand side relates to the Seebeck coefficient S, left y-intercept on the right hand side relates to the electrical conductivity $\sigma$, and right y-intercept on the right hand side relates to the power factor $S^2\sigma$).

Fig. 6: Variation of TE parameters $\sigma$, S, and $S^2\sigma$ (power factor) depending on the thickness time for printed 0.4Ag-0.6Se films containing Ag powder (Example 6) (y-intercept on the left hand side relates to the Seebeck coefficient S, left y-intercept on the right hand side relates to the power factor $S^2\sigma$, and right y-intercept on the right hand side relates to the electrical conductivity a).

Fig. 7: Temperature dependent thermal conductivity $\kappa$ of as prepared printed 0.3Ag-0.7Se films showing insignificant change in $\kappa$ with very low absolute values (Example 6).

Fig. 8: Variation of TE parameters $\sigma$, S, and $S^2\sigma$ (power factor) with sintering time for polystyrene-based screen printed 0.3Ag-0.7Se films (Example 7) (y-intercept on the left hand side relates to the Seebeck coefficient S, left y-intercept on the right hand side relates to the electrical conductivity $\sigma$, and right y-intercept on the right hand side relates to the power factor $S^2\sigma$).

Fig. 9: Sintering time dependent TE parameters $\sigma$, S, and $S^2\sigma$ (power factor) of polystyrene-based 0.5Ag-0.5Se films prepared by stirring the ink for 48 hours followed by sintering at 200°C (Example 8) (y-intercept on the left hand side relates to the Seebeck coefficient S, left y-intercept on the right hand side relates to the electrical conductivity $\sigma$, and right y-intercept on the right hand side relates to the power factor $S^2\sigma$).

Fig. 10: Fabricated f-TEG of Example 11.

Fig. 11: Temperature dependent performance of f-TEG of Example 11 (y-intercept on the left hand side relates to the device resistance, left y-intercept on the right hand side relates to the output voltage, and right y-intercept on the right hand side relates to the maximum output power.

As mentioned above, the present invention is based on a novel strategy for producing a flexible printed Ag-Se-based n-type thermoelectric (TE) material which is based on a moderate temperature post printing sintering procedure in order to avoid detrimental effects at grain boundaries preserving its high TE performance. According to the present invention, an Ag-Se-based ink composition is used for producing n-type printable TE materials, which comprises a mixture of Ag and Se powders as well as a thermoplastic resin as organic binder dissolved in an organic solvent. The weight ratio of the Ag powder to the Se powder in the Ag-Se-based ink composition expressed by the formula (1-x)Ag : xSe is in the range of $0.20 < x \leq 0.80$. Hereinafter, said weight ratio of the Ag powder to the Se powder in the Ag-Se-based ink composition will also be expressed as (1-x)Ag-xSe.

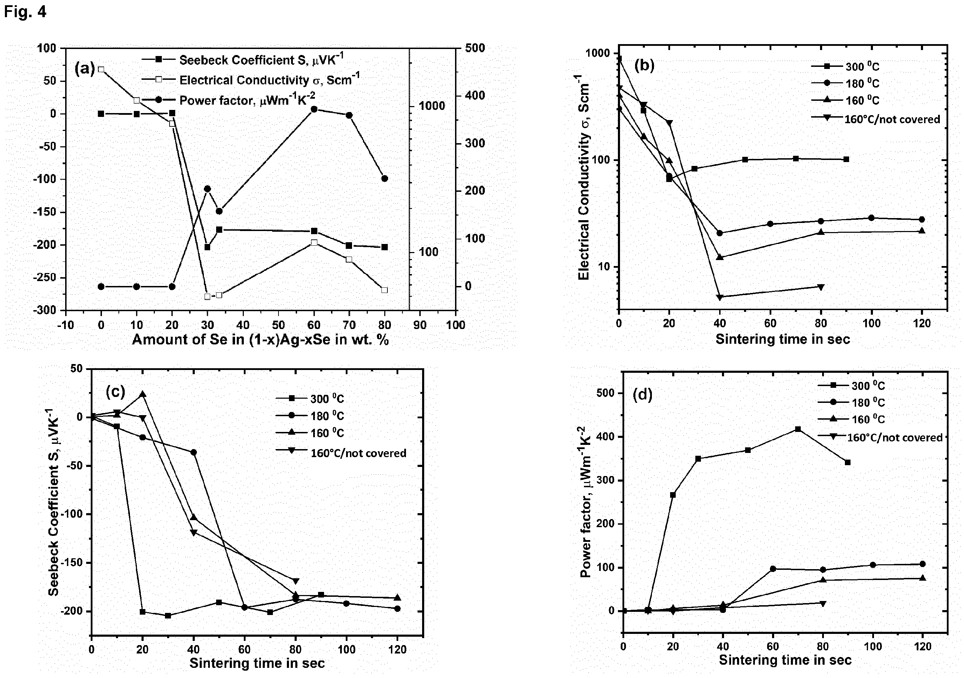

As will be described in more detail in the examples below, it has been found that if the weight ratio of the Ag powder to the Se powder in the ink composition is within the above-mentioned range, the resulting printed Ag-Se-based n-type TE material has an excellent power factor ($S^2\sigma$) as well as an excellent thermoelectric figure-of-merit (zT). This is due to the fact that if the amount of Se in terms of the weight ratio of Se powder to the Ag powder in the ink composition is x < 0.20, i.e. the weight ratio of Ag powder to Se powder is more than 0.80Ag:0.20Se, the Seebeck coefficient S remains almost unchanged up to about x = 0.2, indicating the existence of a percolation path of Ag in the printed film as shown in Fig. 4(a). At a weight ratio of less than 0.80Ag:0.20Se, i.e. x > 0.20, the Seebeck coefficient S is found to increase significantly from 1.2 to -203.3 $\mu VK^{-1}$ after discontinuation of the Ag percolation path due to formation of $Ag_2Se$ phase. According to the present invention, the Seebeck coefficient S is found to be significantly higher compared to that of bulk $Ag_2Se$ for the films having a weight ratio of (1-x)Ag:xSe with x > 0.20. On the other hand, if the weight ratio x of Se is more than 0.80, even though the Seebeck coefficient S remains constant, as shown in Fig. 4(a), the electrical conductivity $\sigma$ decreases resulting in a decreased power factor. Thus, the weight ratio of the Ag powder to the Se powder (1-x)Ag-xSe is in the range of 0.20 < x < 0.80, preferably $0.25 \leq x \leq 0.80$.

Besides, the Ag-Se-based ink composition for n-type printable TE materials according to the present invention further comprises a thermoplastic resin as organic binder. Said thermoplastic resin is dissolved in an organic solvent. The thermoplastic resin is not specifically limited as long as it can be dissolved in the organic solvent. Here, it should be noted that all materials comprised in the inventive ink composition are commonly commercially available.

The polymeric binder is comprised in the inventive ink composition as a film-forming additive. Suitable binders are readily soluble in organic solvents and enable for instance the formation of scratch-resistant films at room temperature. In addition, the binder should impart good stability to the dried films and ensure that there are no visible cracks on the surface.

Suitable polymeric binders are acrylonitrile butadiene styrene (ABS), polycarbonate (PC), polyethylene (PE), polypropylene (PP), polyvinylidene fluoride (PVDF), polyvinyl chloride (PVC), or polystyrene based resins, or corresponding copolymers thereof. Preferably, the thermoplastic resin is selected from polystyrene and polystyrene copolymers.

The polymeric binders may have a weight average molecular weight Mw of about 10,000 to 5,000,000 g/mol, preferably of about 50,000 to 1,000,000 g/mol, more preferably of about 100,000 to 500,000 g/mol.

The thermoplastic resin used as the binder is generally commercially available, and the weight average molecular weight Mw of the thermoplastic resin refers to the value specified by the manufacturer's data. In case these data are not available, the weight average molecular weight Mw of the thermoplastic resin used as a binder is determined by gel permeation chromatography (GPC) normalized to commonly used standards i.e. polystyrene or polyethylene glycol/oxide (PEG/PEO) known to the skilled person.

According to a particularly preferred embodiment of the present invention, the thermoplastic resin is polystyrene having a weight average molecular weight Mw of about 10,000 to 5,000,000 g/mol, preferably of about 50,000 to 1,000,000 g/mol, more preferably of about 100,000 to 500,000 g/mol.

Suitable solvents for the thermoplastic resin are organic solvents, particularly organic solvents having a boiling point of at least 100°C, and in which the thermoplastic resin is soluble. Preferably, the organic solvent may be selected from the group consisting of toluene, ethylbenzene, chlorobenzene, N,N-dimethylformamide, cyclohexanol, cyclohexanone, and mixtures thereof.

The mixing ratio of the thermoplastic resin in the organic solvent is not specifically limited and merely depends on the solubility of the resin in the specific solvent and/or on the desired viscosity of the ink. Generally, the weight ratio of the thermoplastic resin to the organic solvent is from 0.1:99.9 to 10:90 without being limited thereto.

Also, the mixing ratio of the Ag and Se powders with the solvent including the thermoplastic resin is not specifically limited. Generally, the weight ratio of the Ag and Se powders to the total weight of the thermoplastic resin and the organic solvent is in the range of 0.1:1 to 10:1.

According to a preferred embodiment of the present invention, the weight ratio of the Ag and Se powders to the total weight of the thermoplastic resin and the organic solvent is in the range of 0.5:1 to 2.5:1, more preferably 1:1 to 2:1.

As mentioned above, the Ag-Se-based ink composition according to the present invention may further comprise one or more additives to control the viscosity and density of the ink, for instance. Preferably, the ink composition according to the present invention further comprises at least one additive selected from siliceous or siliceous and aluminous materials. Most preferably, the ink composition comprises silica fume. Of course, other additives may be comprised in the ink composition in order to adjust other properties of the resulting TE material.

The amount of the additive(s) may range from 0.001 to 1.0 wt.-% based on the total weight of the ink composition.

Furthermore, the particle size of the Ag and Se powders is not specifically limited and may be selected depending on the desired application of the TE material and/or commercially availability. Generally, suitable Ag and Se powders have a particle size of 200 $\mu m$ or less. Preferably, the particle size of the Ag powder is 10.0 $\mu m$ or less, more preferably 1.0 $\mu m$ or less, and most preferably 500 nm or less.

Compared to the particle size of the Ag powder, the particle size of the Se powder is less influential on the performance of the resulting TE material, since the Se particles start to melt during sintering and react with Ag to form

the binary $Ag_2Se$ phase. Nonetheless, the particle size of the Se powder is preferably 150 $\mu$m or less, and more preferably 50 $\mu$m or less.

Even though the lower limit of the particle size is not specifically restricted, the Ag and Se powders have preferably a particle size of at least 10 nm, more preferably of at least 100 nm, in particular for inkjet printable ink. The upper limit of the particle size of the Ag and Se powders refers to the maximum particle size of each powder, which is commonly specified by the manufacturer's data or to be measured by laser diffraction analysis especially for smaller particles, or by sieve analysis for bigger particles.

The ink composition according to the present invention can be prepared by conventional mixing procedures. For instance, without being limited thereto, the ink composition may be prepared by mixing the Se powder with the Ag powder in the specific weight ratio and optional additives in a solution of thermoplastic resin using a magnetic stirrer. Of course, other mixing devices may be employed to reduce particle size and to obtain a homogenous mixture of the aforementioned components. The mixing may be carried out at room temperature (RT), i.e. of about 20°C, or at higher temperatures. A homogenous mixture of the Se and Ag powders in the organic binder is usually achieved after stirring for at least 5 min.

Thereafter, in order to produce a flexible printed Ag-Se-based n-type TE material, the Ag-Se-based ink composition is printed onto a substrate to preferably form a film of the Ag-Se-based ink composition. Subsequently, according to the present invention, the Ag-Se-based ink composition, which is preferably in the form of a film, is sintered at a temperature of 160°C to 350°C.

In order to provide the printed film, any method known in the art may be employed capable to coat the ink composition onto a substrate. Preferably, screen printing, doctor blading, airbrushing or inkjet printing methods are applied to form the printed film. These methods usually provide a two-dimensional (2D) layer of the ink composition. However, the present invention is not limited to 2D films, but the Ag-Se-based ink composition may also be used in three-dimensional (3D) printing techniques.

Preferably, the method for producing a flexible printed Ag-Se-based n-type TE material comprises the step of printing the Ag-Se-based ink composition onto the substrate to form a film of the Ag-Se-based ink composition in terms of 2D printing. Compared to 3D printing, 2D printing technology is superior insofar that it is fast and inexpensive and a facile process. Also, 2D printing technology affords the production of large-scale films.

The substrate is not specifically limited and commonly used substrates such as a glass substrate, or substrates for flexible integrated circuits may be used. However, preferably, the substrate is flexible and thin polyethylene naphthalate (PEN) or polyethylene terephthalate (PET) films are most preferred.

After printing the Ag-Se-based ink composition onto the substrate, the printed ink composition, which is preferably in the form of a film, is sintered at a temperature of 160°C to 350°C. Ag and Se in the ink remain unreacted up to 150°C, but react at higher temperatures forming high temperature cubic $\alpha$-$Ag_2Se$ phase. For instance, when a (0.3)Ag-(0.7)Se film (i.e. a weight ratio of Ag to Se of 0.3:0.7) is sintered at 200°C, the color changes from grey to black indicating the alteration of the optical bandgap due to formation of the $\alpha$-$Ag_2Se$ phase as will be described in more detail in the following examples. Preferably, the Ag-Se-based ink composition is sintered at a temperature of 200°C to 300°C.

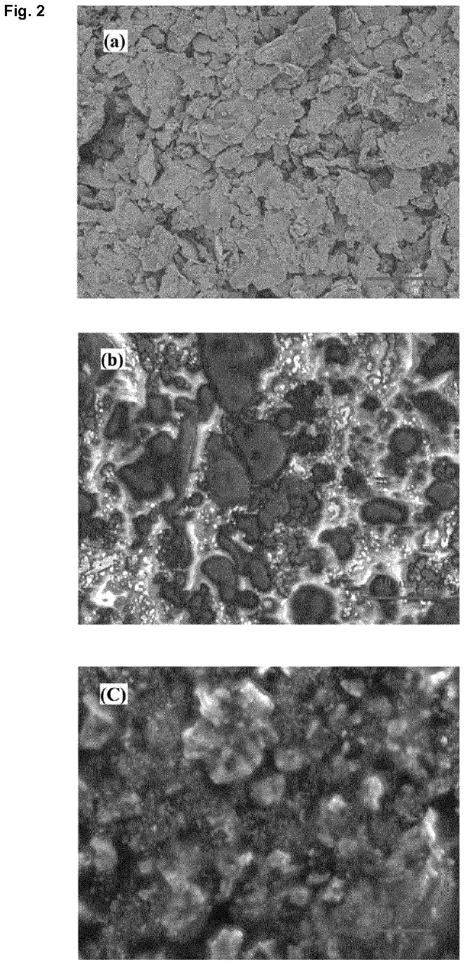

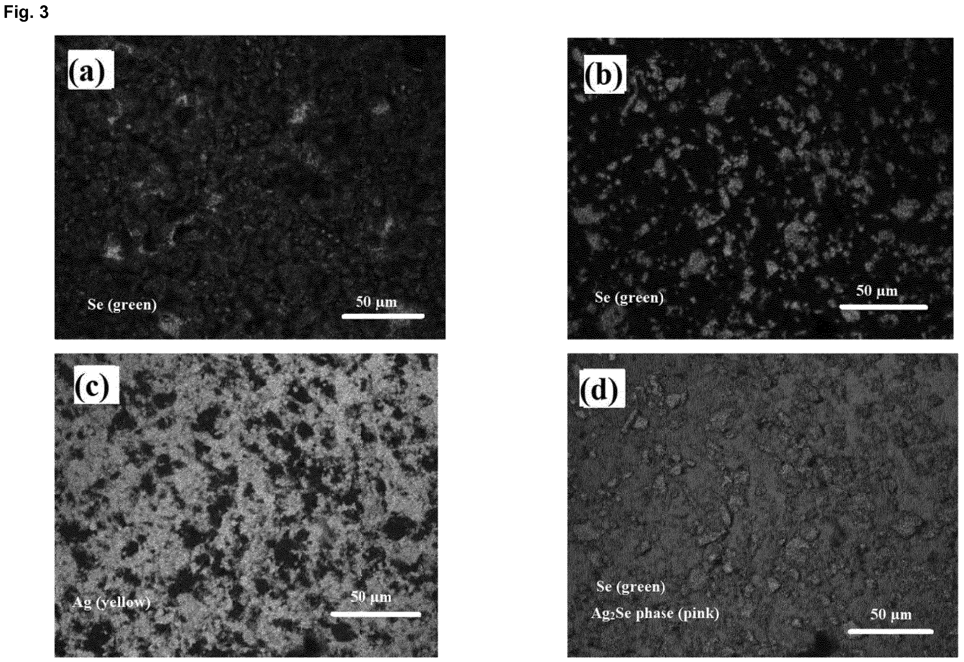

During the sintering process, in the as prepared Ag-Se-based ink composition, Se particles which are homogenously distributed, start to melt and react with Ag to form the binary $Ag_2Se$ phase. As shown in Figs. 2 and 3, for instance, islands of Se are formed which are embedded in the binary $Ag_2Se$ phase. Due to the formation of liquid Se before forming $Ag_2Se$ by reacting with Ag, the charge and phonon transports take place through the percolated path of the targeted $Ag_2Se$ phase. In addition, no defined grain boundary is formed. Thus, unlike conventional inorganic powder based printed films containing grain boundaries, interruption of carrier transport through the percolated path of targeted $Ag_2Se$ phase can be minimized in the present invention, which results in an advantageously high electrical conductivity $\sigma$.

According to the present invention, the sintering time is not specifically limited and depends on the sintering temperature. In particular, it has been found that higher sintering temperature and short sintering time lead to higher TE performance. Preferably, however, the step of sintering is carried out for at least 60 seconds. The upper limit of the sintering time is preferably 15 min or less.

Sintering may be carried out either under an inert atmosphere, such as Ar, $N_2$ etc., or in ambient atmosphere. It is preferred that the sintering is carried out multiple times, such as at least three, four, five, six, seven, eight, nine or ten times, for a total of 15 minutes or less.

According to the present invention, the films of the Ag-Se-based ink composition may also be covered during sintering with e.g. a printable methylcellulose solution or any other suitable polymeric solution in order to lower oxidation.

Furthermore, after printing the Ag-Se-based ink composition onto the substrate and before sintering, the Ag-Se-based ink composition may be dried e.g. at a temperature of 50 to 120°C in order to evaporate the solvent.

As mentioned above, the resulting flexible printed Ag-Se-based n-type TE material obtainable by the method according to the present invention comprises a binary $Ag_2Se$ phase. Due to the moderate temperature post printing sintering procedure, no defined grain boundary is formed in the TE material which results in advantageously high electrical conductivity $\sigma$, and thus in an improved TE performance.

Thus, the present invention provides high performance Ag-Se-based n-type printed TE materials having very high Seebeck coefficients (S) of e.g. more than 200 $\mu VK^{-1}$ with an excellent TE power factor of even more than 700 $\mu Wm^{-1}K^{-2}$ at room temperature. In addition, very high figure-of-merit of about 1.12 has been realized as will be described in more detail in the examples below.

According to the present invention, it is possible to provide a flexible Ag-Se-based n-type printed TE material in the micrometer scale. According to a preferred embodiment, the thickness of the flexible printed Ag-Se-based n-type TE material is in the range of 10 to 100 $\mu m$, more preferably 20 to 50 $\mu m$.

Using the TE material according to the present invention for n-type legs, a flexible printed TE generator can be provided. Thus, the present invention further relates to a flexible printed thermoelectric generator (f-TEG) comprising the flexible printed Ag-Se-based n-type thermoelectric material as n-type legs. In particular, the f-TEG according to the present invention may comprise several to more than 1000 thermocouples using the flexible printed Ag-Se-based n-type TE material as n-type legs.

According to a preferred embodiment, the f-TEG comprises p-type legs made of a printable conductive polymer selected from p-doped poly(3,4-ethylenedioxythiophene)-based polymers PEDOT-based polymers). Said PEDOT-based polymers are not particularly limited and may include those described e.g. in EP 3 477 718 A1 without being limited thereto.

The flexible printed Ag-Se-based n-type TE material according to the present invention can be employed for commercial applications for high power density printed f-TEG due to its high TE performance, reproducibility and stability. The printed f-TEGs can have manifold applications in waste heat recovery device in industrial applications, geothermal energy, vehicles, body heat harvester and energy harvesting for autonomous sensor systems. Apart from waste heat recovery applications, the printed f-TEGs can be used for cooling applications. In particular, the f-TEGs according to the present invention can be integrated with wearable materials, such as helmets or cloths, in order to maintain or lower a body temperature.

The present invention will be further illustrated in the following examples without being limited thereto.

## Examples

*Materials:*

The following materials were used in the following examples. Se powder (-100 mesh, >99.5% trace metals basis, Sigma Aldrich), Ag powder (2-3.5 $\mu m$, >99.9% trace metals basis, Sigma Aldrich), methyl cellulose (METHOCEL HG 90, Sigma Aldrich), polystyrene (average Mw - 192,000, Sigma Aldrich), Acheson Silver DAG 1415M (silver paste, Agar scientific), silica fume (Evonik) and PEDOT:PSS PH1000 (Heraeus).

*Characterization methods:*

Crystallographic and phase analysis of the printed films were performed by X-ray diffraction technique using the Cu-K$\alpha$ radiation on a BRUKER D5000 diffractometer. The phase formation and transformation were tracked using DTA analysis. Morphological and microstructural analysis were done by secondary electron microscopy (SEM, FEI XL30S, PHILIPS). Elemental analysis was performed using electron probe micro-analyzer (EPMA, JOEL). The thickness of the printed films was determined by BRUKER 3D Microscopes based on white light interferometer (WLI). The Seebeck coefficient S and electrical conductivity ($\sigma$) of the films were determined at RT using a custom-built setup with an experimental error associated with the measurement of about 10%. The Seebeck measurement setup uses two temperature-controlled copper blocks in close proximity, which generate a temperature difference. The sample is placed across the two blocks and the temperature is measured on each side of the sample with two temperature sensors being pressed onto the sample. The Seebeck-voltage is measured between these two tips to ensure the thermal and the electrical measurement happens at the same position on the sample. The thermal conductivity ($\kappa$) of a printed film was determined using a Linseis thin film analysis (TFA) system. Hall coefficient ($R_H$) and Hall voltage ($V_H$) were measured at RT using the rectangular bar sample with a Quantum Design Physical Property Measurement System (PPMS) system.

*General overview*

At first, the inks were prepared by mixing Se powder with Acheson Silver DAG 1415M in a solution of thermoplastic resin using a magnetic stirrer for 1 hour at 1200 rpm. The Ag-Se based inks have been printed using manual doctor blading and screen printing followed by short time sintering for the formation of $Ag_2Se$ TE phase. The wt. % of Se in the printed films (1-x)Ag-xSe on the glass substrate varies from 0 to 80 % ($0 \leq x \leq 0.80$) with a weight ratio of the (1-x)Ag-xSe to the solvent in the inks of approximately 6:4 in order to study the TE properties of the printed films. The films were covered with a printable methylcellulose solution (methylcellulose: ethanol: $H_2O$= 2: 59: 39 in wt. %) to prevent them from oxidation and dried at 100°C before sintering at different temperatures. Then, the as prepared printed films were sintered multiple times at different temperatures in $N_2$ flow for very short duration of time.

Henceforward, the Acheson Silver DAG thermoplastic solvent was replaced by polystyrene-toluene solution (6:94 in wt. ratio) to tackle the increase of film resistivity due to oxidation for long sintering time.

In addition, Ag powder was used instead of Ag paste in the polystyrene-toluene solution with 0.05-0.1 wt. % silica fume followed by stirring for 72 hr for commercial applications.

*Example 1*

Ag-Se-based ink compositions were prepared by mixing Se powder with Acheson Silver DAG 1415M in a solution of thermoplastic resin using a magnetic stirrer (1200 rpm) for 1 hour at room temperature (RT). The wt.-% of Se in the ink was (0.3)Ag-(0.7)Se with a weight ratio of (0.3)Ag-(0.7)Se to the solvent in the inks of approximately 6:4. The Ag-Se based inks were printed on a glass substrate using manual doctor blading followed by short time sintering for the formation of $Ag_2Se$ TE phase.

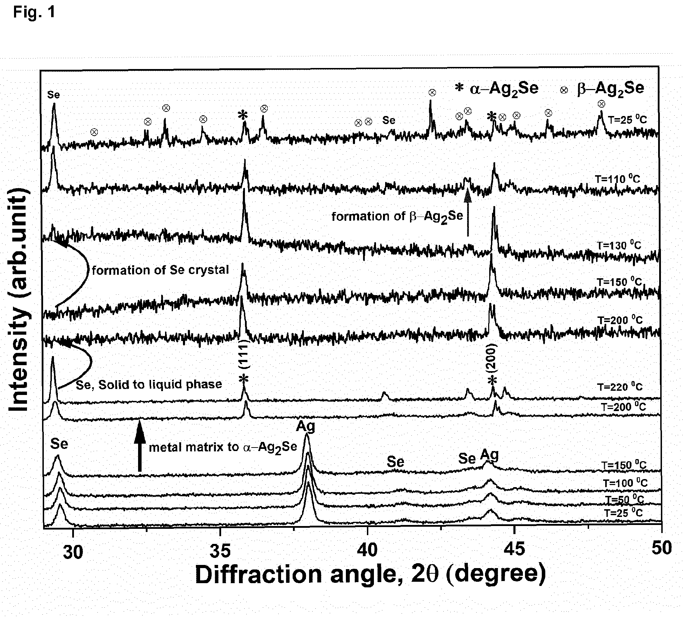

Phase identification and crystallographic structural analysis of the printed films were done using BRUKER diffractometer with the Cu K$\alpha$ radiation. Figure 1 shows temperature (T) dependent (heating and cooling) X-ray diffraction pattern of (0.3)Ag-(0.7)Se printed film signifying the formation and transition of different phases. During heating, the XRD patterns indicate that the elements Ag and Se in the ink remain unreacted up to 150 °C and found to be reacted at 200°C forming high temperature cubic $\alpha$-$Ag_2Se$ phase. When the (0.3)Ag-(0.7)Se film is sintered at 200°C, it is also observed that its color changes from grey to black indicating the alteration of the optical bandgap due to formation of $\alpha$-$Ag_2Se$ phase. After reaching T=220°C, the $\alpha$-$Ag_2Se$ is found to be the dominant phase along with excess elemental Se where Ag is found to be fully reacted. However, the peaks at $2\theta$=29.30°, 40.60° and 43.46°, correspond to excess crystalline Se, which disappeared after attaining T=220 °C due to the transformation of crystalline to liquid phase. The prominent peak at $2\theta$=29.30° starts to appear again and becomes significant indicating restructuring of Se crystal along-side transition of cubic $\alpha$-$Ag_2Se$ to orthorhombic $\beta$-$Ag_2Se$ phase when the temperature is cooled down to T<130°C.

Predominantly low temperature orthorhombic $\beta$-$Ag_2Se$ phase together with residual $\alpha$-$Ag_2Se$ phase and unre-acted excess Se are found when the temperature cooled down to T=25°C. The presence of residual $\alpha$-$Ag_2Se$ phase is probably due to lack of time to complete the transformation of the phase during XRD measurement.

However, the residual $\alpha$-$Ag_2Se$ phase has not been found in the RT slow scan XRD pattern of the short time sintered film. Rietveld refinement of XRD patterns of the film at 200°C during cooling and short time sintered film at RT were done using the FULLPROF program. The results of refinement for the films together with the refinement parameters are shown in Table 1.

Table 1:

| Chemical Composition | Lattice parameter, nm | | | Wyckoff positions | | |
|---|---|---|---|---|---|---|
| | **A** | **b** | **C** | **4a** | **2a** | **12d** |
| $\alpha$-$Ag_2Se$ | 0.4987(8) | 0.4987(8) | 0.4987(8) | - | Se | Ag |
| $\beta$-$Ag_2Se$ | 0.4324(4) | 0.7062(6) | 0.7780 (7) | Ag, Se | - | - |

The structural analysis indicates that the film at 200°C has a cubic phase belonging to the space group I m -3 m and the two base atoms Ag and Se are situated in the two inequivalent positions 12d (1/4, 1/2, 0) and 2a (0, 0, 0) respectively. The highest significant peaks at $2\theta$=35.80° and $2\theta$=44.38° are found to be corresponded to cubic $\alpha$-$Ag_2Se$ phase with a lattice parameter a=0.4987 nm. The RT structural analysis of the sintered film shows that the phase of the film is corresponding to a main orthorhombic $\beta$-$Ag_2Se$ phase belonging to space group $P2_12_12_1$ together with excess Se and very small amount of Ag. The lattice parameters of the $\beta$-$Ag_2Se$ phase are estimated to be a=0.4324(4) nm, b=0.7062(6) nm and c=0.7780 (7) nm. Both Ag and Se atoms in $\beta$-$Ag_2Se$ phase are found to occupy 4a (x, y, z) position.

Microstructural and morphological analysis of the alloys are shown in the SEM images of Figs. 2(a)-(c). Morphologies of the surfaces of as prepared (dried at 100°C), partially reacted (sintered for 30 sec) and fully reacted (sintered for 120 sec) films at 200°C have been analyzed. The Se is found to be uniformly distributed in the as prepared film as shown in Fig. 2(a). As shown in Figs. 2(a) and (b), for both the partially and fully reacted films, islands of Se in the order of $\mu$m are formed which appear to be embedded in the binary $Ag_2Se$ phase. SEM images indicate that the Se particles start to melt from the edges and react with Ag to form $Ag_2Se$ phase during the sintering process. EPMA analysis of the as prepared and fully reacted films is consistent with the SEM data. It is clearly visualized in Figs. 3(a)-(d) that Se is homogenously distributed (green region) in the as-prepared film but not in the fully reacted film. In addition, a homogeneous distribution of Ag is found where the $Ag_2Se$ phase is formed (yellow region). In order to confirm the structural phase transition, from orthorhombic $\beta$-$Ag_2Se$ to cubic $\alpha$-$Ag_2Se$, i.e. RT to high temperature, DTA analysis has been done for the partially reacted sample. Two peaks are found at T=404 K and 483 K which are corresponding to structural phase transition and cubic $\alpha$-$Ag_2Se$ phase forming temperature, consistent with XRD results. The results demonstrate the formation of $Ag_2Se$ phase reducing the elemental Se.

*Example 2*

Ag-Se-based ink compositions were prepared and printed similar to Example 1. The wt.-% of Se in the printed films (1-x)Ag-xSe on the glass substrate varied from 0 to 80 % ($0 \leq x \leq 0.80$) with a weight ratio of the (1-x)Ag-xSe to the solvent in the inks of approximately 6:4 in order to study the TE properties of the printed films. The films were covered with a printable methylcellulose solution (methylcellulose : ethanol: $H_2O$ = 2 : 59 : 39 in wt.-%) to prevent them from oxidation and dried at 100°C before sintering at different temperatures. The as prepared printed films were sintered multiple times at different temperatures in an $N_2$ flow for very short duration of time.

At first, the TE transport properties of the printed films have been studied after sintering multiple times at 300°C for a total of 90 secs. The composition dependent TE parameters, S and $\sigma$ of the sintered films are shown in Fig. 4 (a). $\sigma$ decreases with increasing Se percentage varying from 1800 to 56 Scm$^{-1}$ with a significant decrease in $\sigma$ at x>0.20 due to reduction of Ag forming $Ag_2Se$ phase. $\sigma$ of near stoichiometric $Ag_2Se$ films with x=0.30 and 0.33 is found to be similar and low before it increases to 117 Scm$^{-1}$ for x=0.60 probably due to fast formation of $Ag_2Se$ phase decreasing Ag as suggested by the Ag-Se phase diagram. However, the exact reason of low $\sigma$ for these compositions remains unexplored.

The Seebeck coefficient S remains almost unchanged up to x=0.2 indicating the existence of a percolation path of Ag in the film and it increases substantially from 1.2 to -203.3 $\mu$VK$^{-1}$ for the compositions x>0.20 after discontinuation of the Ag percolation path due to formation of $Ag_2Se$ phase. The S is found to be significantly higher compared to that of bulk $Ag_2Se$ for the films x>0.20. Hence, a highest power factor of 360 $\mu$Wm$^{-1}$K$^{-2}$ for the composition with x=0.60 has been achieved.

Due to the formation of a liquid phase of Se before forming $Ag_2Se$ reacting with Ag, no defined grain boundary is formed as seen in the SEM image. Therefore, unlike conventional inorganic powder based printed films containing grain boundaries, interruption of carrier transportation through the percolated path of targeted $Ag_2Se$ phase, has been minimized in this system. It is observed that S does not alter significantly while $\sigma$ starts to decrease for x>0.60 due to increase in volume % of Se and oxidation. This detrimental effect could be avoided by decreasing sintering time. Nevertheless, as the sintering at temperatures of more than e.g. 400°C is not feasible for printed TE device fabrication on most flexible substrates, TE performance of the films has been studied to optimize at lower sintering temperature increasing sintering time (cf. Example 3).

*Example 3*

The TE parameters of the printed film 0.3Ag-0.7Se prepared similar to example 1, has been studied for different sintering temperatures, namely 300°C, 180°C and 160°C with six consecutive short sintering times as shown in Figs. 4 (b)-(d). The sintering times required to form a percolation path of $Ag_2Se$ phase reducing Ag in the printed film 0.3Ag-0.7Se are found to be 20, 60 and 80 secs for the sintering temperatures 300°C, 180°C and 160°C, respectively. The $\sigma$ decreases with increasing sintering time and the lowest $\sigma$ for the different sintering temperatures varies from 100 to 20 Scm$^{-1}$. It has been found that higher sintering temperature and short sintering time lead to higher TE performance, hence a highest power factor of approximately 420 $\mu$Wm$^{-1}$K$^{-2}$ has been exhibited by the film sintered at 300°C for a total of 70 secs as shown in Fig. 4 (d). Although the S reaches approximately-200 $\mu$VK$^{-1}$ for all the sintering temperatures after the formation of the $Ag_2Se$ phase, the power factor has not been enhanced significantly for the films sintered at 180°C and 160°C due to a decrease in conductivity during the long sintering process probably because of the oxidation of Se.

*Example 4*

The films of Examples 2 and 3 were covered with methylcellulose (MC) printable layer in order to lower oxidation. As shown in Figs. 4(b) and (d), the example without a covered film shows lower conductivity than that of covered film at 160°C leading to a lower power factor. However, oxidation prevention was not effective enough to maintain a high power factor. Hence, in order to prevent the printed films from oxidation after the formation of percolation path of $Ag_2Se$, the Acheson thermoplastic ink has been replaced by a polystyrene-toluene solution (6:94 in wt. ratio) in order to tackle the increase of film resistivity for long sintering time.

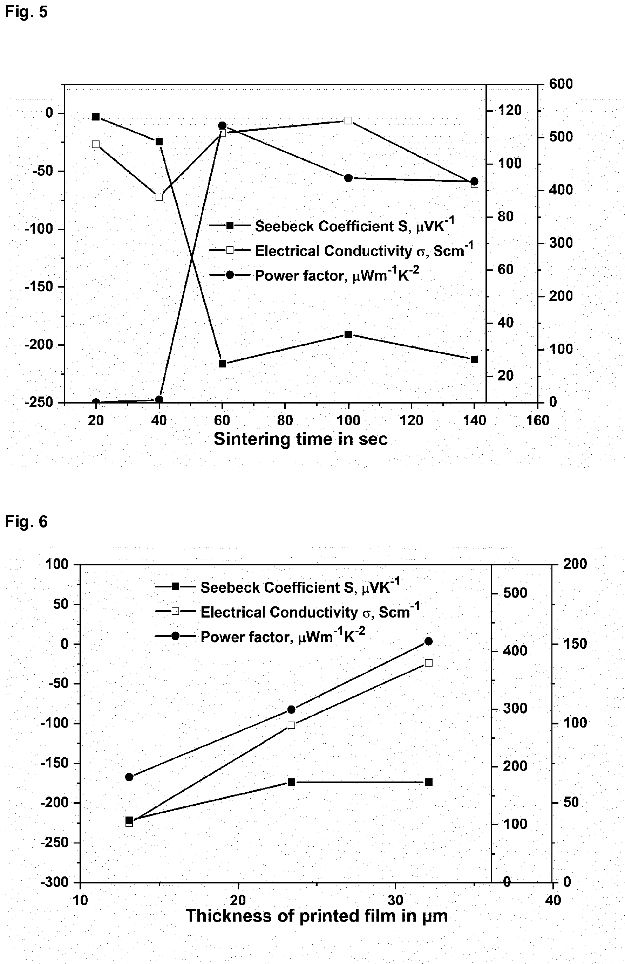

The TE ink was prepared by mixing Se powder with Ag paste in the solution of polystyrene-toluene solution using a magnetic stirrer. The Ag-Se based ink has been printed using manual doctor blading followed by sintering at 200°C to prepare the film 0.3Ag-0.7Se. It has been found that the printed polystyrene-based TE films sustain ambient atmosphere and are stable when the sintering time exceeds 10 min at 200°C. A highest S of -216 $\mu$VK$^{-1}$ together with

a conductivity of 110 Scm$^{-1}$ and consequently a high power factor of 522 $\mu$Wm$^{-1}$K$^{-2}$ has been achieved for the polystyrene ink based printed film (cf. Fig. 5).

*Example 5*

An Ag powder with 2-3.5 $\mu$m was used instead of the Ag paste in the polystyrene-toluene solution with 0.05-0.1 wt. % silica fume. The Ag powder-based ink was prepared by mixing Se powder with the Ag powder in the solution of polystyrene-toluene. The Ag powder-based film 0.3Ag-0.7Se has been printed using manual doctor blading followed by sintering at 200°C.

The TE performance of Ag powder of $\mu$m order based printed film 0.3Ag-0.7Se prepared by a similar method as described in Example 4 is found to be low with a power factor of about 31 $\mu$Wm$^{-1}$K$^{-2}$ due to low $\sigma$. The low $\sigma$ in the printed film is due to larger particle size of Ag powder slowing down the reaction to form Ag$_2$Se phase.

*Example 6*

The film 0.4Ag-0.6Se was prepared and printed similar to example 5.

The RT TE performance of Ag powder of $\mu$m order based printed films 0.4Ag-0.6Se has been studied after stirring for 3 days followed by sintering at 200°C for 10 min for large scale applications. Although S is altered with thickness for 0.4Ag-0.6Se, as shown in Fig. 6, the $\sigma$ is increased with increasing thickness indicating increase of per-colation paths of Ag$_2$Se phase. A power factor of 420 $\mu$Wm$^{-1}$K$^{-2}$ is achieved in the printed films 0.4Ag-0.6Se.

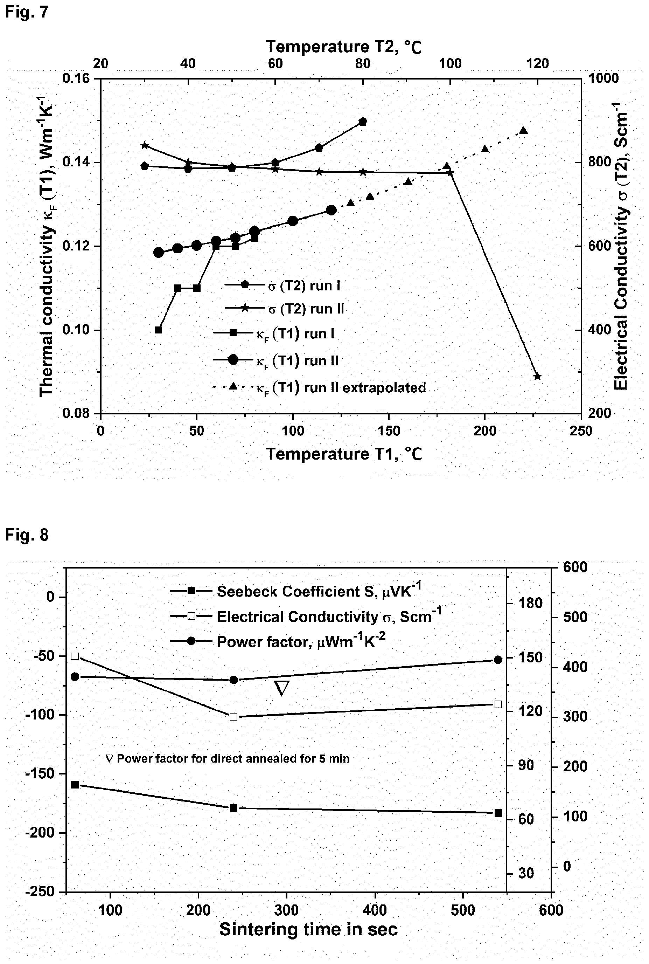

The temperature dependent in plane thermal conductivity $\kappa$ of the as prepared film has been determined in the temperature range of 30 to 130°C (cf. Fig. 7). The $\kappa$ is found to be very low at all temperatures with a little increment at elevated temperatures. A very low $\kappa$ value of 0.125 Wm$^{-1}$K$^{-1}$ is found with a high $\sigma$ of 775 Scm$^{-1}$ at 100°C. The meas-urements of $\kappa$ values at T>130°C have not been possible using Linseis TFA system due to contact problems because of the thermal expansion of the printed film. However, it can be assumed that the $\kappa$ value will not be significantly increased rather can be decreased as the $\sigma$ is found to be decreased significantly by about 65% after formation of the Ag$_2$Se phase reducing volume % of high thermal conductivity Ag element at higher temperatures. In order to calculate TE figure-of-merit zT of the film, the temperature dependent $\kappa$ data has been extrapolated to estimate the $\kappa$ at T>200 °C. A zT of about 1 has been realized using the $\kappa$ of about 0.14 Wm$^{-1}$K$^{-1}$ which is a very high value for any printed TE material.

*Example 7*

The TE performance of manual screen printed 0.3Ag-0.7Se based TE film using polystyrene-based ink prepared similar to example 4 has also been studied.

The screen printed film exhibits a high power factor of 415 $\mu$Wm$^{-1}$K$^{-2}$ maintaining a high conductivity value of 124 Scm$^{-1}$ even after sintering for 540 secs at 200°C as shown in Fig. 8. The printed film is found to be environmentally stable, reproducible and has a repeatable TE performance. After the optimization of TE performance, to check the screen printability, the TE ink has been printed on a flexible polyethylene terephthalate (PET) substrate using a semiautomatic flat-screen ROKUPRINT printing machine.

*Example 8*

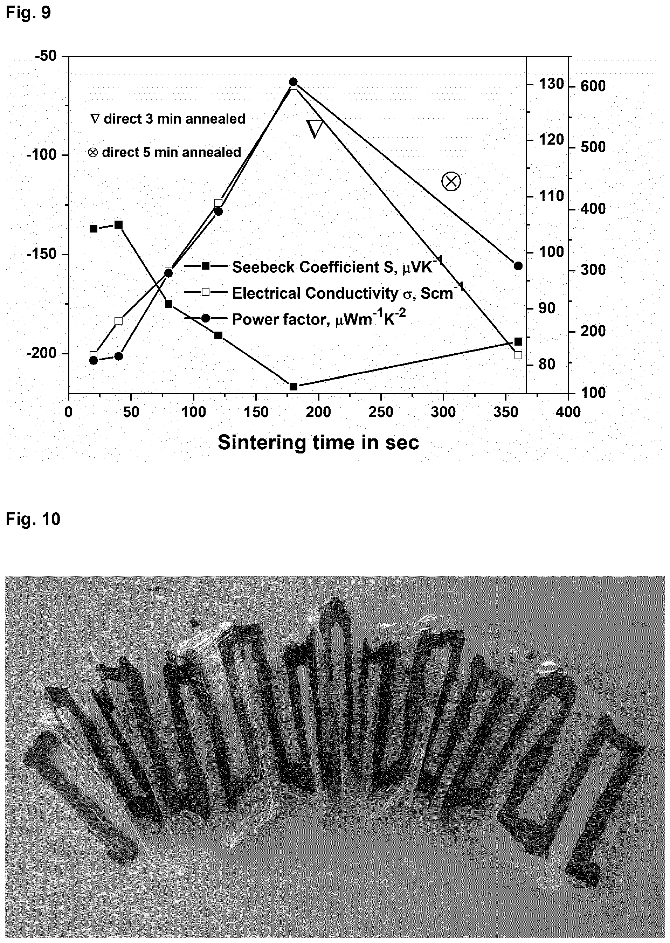

A polystyrene-based 0.5Ag-0.5Se ink was prepared similar to example 5 by stirring for 72 hrs followed by sintering either directly or for multiple times for 20 to 360 secs in total at 200°C. Thereafter, TE performance of printed film has been studied. It is interesting to observe that a very high power factor value of 608 $\mu$Wm$^{-1}$K$^{-2}$ is achieved just after sintering multiple times for 180 secs in total at 200°C as shown in Fig. 9. When comparing the results with that of direct sintering for 180 secs, it is found that a power factor of 541 $\mu$Wm$^{-1}$K$^{-2}$ is attained in the film sintered directly for 180 secs at 200°C. However, the TE performance is decreased when the direct sintering time is 300 secs.

*Example 9*

The RT TE performance of Ag powder based printed films of stoichiometric 0.73Ag-0.27Se has also been studied using the ink prepared similar to example 5 after stirring for 3 days followed by sintering at 200°C for 10 min. A power factor of 713 $\mu$Wm$^{-1}$K$^{-2}$ is achieved in the stoichiometric printed film 0.73Ag-0.27Se. Together with an S of 210 $\mu$VK$^{-1}$, the $\sigma$ for the stoichiometric film is found to be about 162 Scm$^{-1}$, which is much higher compared to that for non-stoichiometric film leading to a higher power factor.

*Example 10*

The room temperature transport parameters Hall coefficient ($R_H$) and carrier concentration ($\eta_H$) were determined by measuring the Hall voltage ($V_H$) at 2.5 T. The $R_H$ is found to be $2.8 \times 10^{-2}$ $m^3C^{-1}$ whereas the $\eta_H$ estimated to be about $2.2 \times 10^{23}$ $m^{-3}$ for the printed 0.3Ag-0.7Se based TE film. The Hall carrier concentration is lower by one order of magnitude compared to that of bulk because of presence of binder and excess Se.

*Example 11*

Using the 0.3Ag-0.7Se based TE ink for n-type legs and commercially available PEDOT:PSS ink for p-type legs, a printed flexible TE generator (f-TEG) of 13 pairs of n-and p-type legs on a thin polyethylene naphthalate (PEN) substrate of 4 $\mu$m thickness has been fabricated. At first, the 13 pairs of n- and p-type legs were applied on the substrate using manual doctor blading technique followed by a folding step (cf. Fig. 10). The f-TEG was then sintered at 200°C for 2-5 min in order to activate the n-type legs. The f-TEG is found to be extremely light (about 0.36 g) and thin (<1 mm) signifying its potential of being a high density power generator.

The performance of the f-TEG has been demonstrated wearing it on the wrist and it is found that a high open circuit voltage (Voc) of 72.2 mV is generated when one side of the f-TEG is in contact with the human body and the other side with a beaker of ice water. Upon removal of the ice-beaker, the $V_{oc}$ also starts to decrease with time.

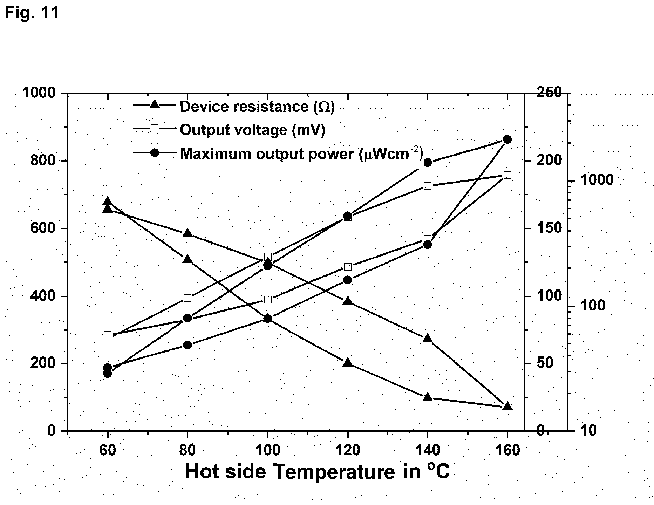

The device performance has also been studied varying the in-plane temperature difference, $30°C \leq \Delta T \leq 130°C$, between two sides of the f-TEG. Cold side temperature of the f-TEG was kept at 30°C and the temperature of the hot-side temperature varied from 60 to 160°C. The $\Delta T$ dependent device resistance ($R_{device}$), $V_{OC}$ and maximum power output ($P_{max}$) have been studied after sintering as shown in Fig. 11.

$P_{max}$ has been estimated by maximum power transfer theorem using the formula

$$P_{max} = V_{OC}^2 \Big/ 4R_{device}.$$

$P_{max}$ is found to be 1.92 and 127.3 $\mu$W when $\Delta T$ is about 30°C and 130°C, respectively. Generally, the $R_{device}$ is found to be decreased, and Voc and $P_{max}$ are found to be increased with increasing $\Delta T$. The decrease in $R_{device}$ is due to phase transition of orthorhombic $\beta$-Ag$_2$Se to cubic superionic phase $\alpha$-Ag$_2$Se at high temperatures. An open circuit voltage $V_{OC}$ of 71.1 mV and 189.5 mV developed for $\Delta T$ of about 30°C and 130°C, respectively. The device maximum power density $P_{max}$ of 2122 $\mu$Wcm$^{-2}$ were estimated for $\Delta T$ = 130°C.

The Seebeck coefficient difference between n- and p-type legs of a thermocouple can be estimated using the following equation (1):

$$(S_p - S_n) = V_{OC} \Big/ \Delta T \times \text{no. of thermocouple} \quad (1)$$

where $S_p$ and $S_n$ are the Seebeck coefficients of the p-type and n-type legs respectively. Using the equation (1), the ($S_p$ — $S_n$) and $S_n$ are estimated to be about 186 $\mu$VK$^{-1}$ and 161 $\mu$VK$^{-1}$, respectively. The value of $S_n$ estimated from the device's output is consistent with that of the printed n-type film. Small mismatch in the values of $S_n$ is probable due to difference between actual and calculated $\Delta T$ during the operation of the f-TEG.

As demonstrated above, high performance Ag-Se based n-type printed TE materials have been developed through a new and fast synthesis approach. Very high Seebeck coefficient (S) of more than -200 $\mu$VK$^{-1}$ with a breakthrough TE power factor of > 700 $\mu$Wm$^{-1}$K$^{-2}$ for an n-type printed film is achieved at room temperature. A very high figure-of-merit (zT) of about 1.12 has been realized with an estimated low thermal conductivity ($\kappa$) of about 0.14 Wm$^{-1}$K$^{-1}$. Using the developed material for n-type legs, a flexible TE generator (f-TEG) of 13 thermocouples has been fabricated. The open-circuit voltage of the f-TEG for $\Delta T$ = 30°C and 130°C are found to be 71.1 mV and 189.5 mV, respectively. Consequently, a very high maximum output power density $P_{max}$ of 2122 $\mu$Wcm$^{-2}$ is estimated for $\Delta T$ = 130°C. The f-TEG has also been demonstrated by wearing it on the lower wrist, which resulted in an output voltage of about 72.2 mV for $\Delta T$ of about 30°C.

**Claims**

1. An Ag-Se-based ink composition for n-type printable thermoelectric materials, comprising a mixture of Ag and Se powders, and a thermoplastic resin as organic binder dissolved in an organic solvent,
wherein the weight ratio of the Ag powder to the Se powder expressed by the formula (1-x)Ag : xSe is in the range of $0.20 < x \leq 0.80$.

2. The Ag-Se-based ink composition according to claim 1, wherein the thermoplastic resin is selected from polystyrene and polystyrene copolymers.

3. The Ag-Se-based ink composition according to claim 1 or 2, wherein the solvent is selected from the group consisting of toluene, ethylbenzene, chlorobenzene, N,N-dimethylformamide, cyclohexanol, cyclohexanone, and mixtures thereof.

4. The Ag-Se-based ink composition according to any one of claims 1 to 3, wherein the weight ratio of the Ag and Se powders to the total weight of the thermoplastic resin and the organic solvent is in the range of 0.5:1 to 2.5:1.

5. The Ag-Se-based ink composition according to any one of claims 1 to 4, further comprising at least one additive selected from siliceous or siliceous and aluminous materials, preferably silica fume.

6. The Ag-Se-based ink composition according to any one of claims 1 to 5, wherein the particle size of the Ag powder is 10.0 $\mu$m or less.

7. The Ag-Se-based ink composition according to any one of claims 1 to 6, wherein the particle size of the Se powder is 150 $\mu$m or less.

8. A method for producing a flexible printed Ag-Se-based n-type thermoelectric material, comprising the steps of:

   - providing the Ag-Se-based ink composition according to any one of claims 1 to 7;
   - printing the Ag-Se-based ink composition onto a substrate; and
   - sintering the Ag-Se-based ink composition at a temperature of 160°C to 350°C.

9. The method according to claim 8, wherein the step of sintering is carried out for at least 60 seconds.

10. The method according to claim 8 or 9, wherein the step of printing the Ag-Se-based ink composition onto the substrate is by at least one selected from the group consisting of screen printing, doctor blading, airbrushing and inkjet printing.

11. A flexible printed Ag-Se-based n-type thermoelectric material obtainable by printing the Ag-Se-based ink composition according to any one of claims 1 to 7 onto a substrate and sintering the Ag-Se-based ink composition at a temperature of 160°C to 350°C, wherein the n-type printed thermoelectric material comprises a binary $Ag_2Se$ phase.

12. The flexible printed Ag-Se-based n-type thermoelectric material according to claim 11 having a thickness of 10 to 100 $\mu$m.

13. A flexible printed thermoelectric generator comprising the flexible printed Ag-Se-based n-type thermoelectric material according to claim 11 or 12 as n-type legs.

14. The flexible printed thermoelectric generator according to claim 13, further comprising p-type legs made of a printable conductive polymer selected from p-doped poly(3,4-ethylenedioxythiophene)-based polymers.

15. Use of the flexible printed thermoelectric generator according to claim 13 or 14 in waste heat recovery applications, or in cooling applications integrated with wearable materials to maintain or lower a body temperature.

**Patentansprüche**

1. Tintenzusammensetzung auf Ag-Se-Basis für druckbare thermoelektrische Materialien vom n-Typ, umfassend ein Gemisch von Ag- und Se-Pulvern und ein thermoplastisches Harz als organisches Bindemittel, gelöst in einem organischen Lösungsmittel,
wobei das Gewichtsverhältnis des Ag-Pulvers zu dem Se-Pulver, ausgedrückt durch die Formel (1-x)Ag : xSe, in dem Bereich von $0,20 < x \leq 0,80$ ist.

**2.** Tintenzusammensetzung auf Ag-Se-Basis gemäß Anspruch 1, wobei das thermoplastische Harz aus Polystyrol und Polystyrol-Copolymeren ausgewählt ist.

**3.** Tintenzusammensetzung auf Ag-Se-Basis gemäß Anspruch 1 oder 2, wobei das Lösungsmittel aus der Gruppe, bestehend aus Toluol, Ethylbenzol, Chlorbenzol, N,N-Dimethylformamid, Cyclohexanol, Cyclohexanon und Gemischen davon, ausgewählt ist.

**4.** Tintenzusammensetzung auf Ag-Se-Basis gemäß einem der Ansprüche 1 bis 3, wobei das Gewichtsverhältnis der Ag- und Se-Pulver zu dem Gesamtgewicht des thermoplastischen Harzes und des organischen Lösungsmittels in dem Bereich von 0,5:1 bis 2.5:1 ist.

**5.** Tintenzusammensetzung auf Ag-Se-Basis gemäß einem der Ansprüche 1 bis 4, weiter umfassend mindestens ein Additiv, ausgewählt aus silikatischen oder silikatischen- und aluminiumhaltigen Materialien, vorzugsweise Silicastaub.

**6.** Tintenzusammensetzung auf Ag-Se-Basis gemäß einem der Ansprüche 1 bis 5, wobei die Teilchengröße des Ag-Pulvers 10,0 $\mu$m oder weniger beträgt.

**7.** Tintenzusammensetzung auf Ag-Se-Basis gemäß einem der Ansprüche 1 bis 6, wobei die Teilchengröße des Se-Pulvers 150 $\mu$m oder weniger beträgt.

**8.** Verfahren zur Herstellung eines flexiblen gedruckten thermoelektrischen Materials auf Ag-Se-Basis vom n-typ, umfassend die Schritte:

- Bereitstellen der Tintenzusammensetzung auf Ag-Se-Basis gemäß einem der Ansprüche 1 bis 7;
- Drucken der Tintenzusammensetzung auf Ag-Se-Basis auf ein Substrat; und
- Sintern der Tintenzusammensetzung auf Ag-Se-Basis bei einer Temperatur von 160°C bis 350°C.

**9.** Verfahren gemäß Anspruch 8, wobei der Schritt des Sinterns für mindestens 60 Sekunden durchgeführt wird.

**10.** Verfahren gemäß Anspruch 8 oder 9, wobei der Schritt des Druckens der Tintenzusammensetzung auf Ag-Se-Basis auf das Substrat durch mindestens eines ist, ausgewählt aus der Gruppe, bestehend aus Siebdrucken, Rakeln, Airbrush und Tintenstrahldruck.

**11.** Flexibles gedrucktes thermoelektrisches Material auf Ag-Se-Basis vom n-Typ, erhältlich durch Drucken der Tintenzusammensetzung auf Ag-Se-Basis gemäß einem der Ansprüche 1 bis 7 auf ein Substrat und Sintern der Tintenzusammensetzung auf Ag-Se-Basis bei einer Temperatur von 160°C bis 350°C, wobei das gedruckte thermoelektrische Material von n-Typ eine binäre $Ag_2Se$-Phase umfasst.

**12.** Flexibles gedrucktes thermoelektrisches Material auf Ag-Se-Basis vom n-Typ gemäß Anspruch 11, mit einer Dicke von 10 bis 100 $\mu$m.

**13.** Flexibler gedruckter thermoelektrischer Generator, umfassend das flexible gedruckte thermoelektrische Material auf Ag-Se-Basis vom n-Typ gemäß Anspruch 11 oder 12 als n-Typ-Schenkel.

**14.** Flexibler gedruckter thermoelektrischer Generator gemäß Anspruch 13, weiter umfassend p-Typ-Schenkel, hergestellt aus einem druckbaren leitfähigen Polymer, ausgewählt aus p-dotierten Poly(3,4-ethylendioxythiophen)-basierenden Polymeren.

**15.** Verwendung des flexiblen gedruckten thermoelektrischen Generators gemäß Anspruch 13 oder 14 bei Anwendungen zur Wärmerückgewinnung oder bei Kühlanwendungen, integriert mit tragbaren Materialien, um eine Körpertemperatur aufrechtzuerhalten oder zu senken.

**Revendications**

**1.** Composition d'encre à base d'Ag-Se pour matériaux thermoélectriques de type n imprimables, comprenant un mélange de poudres d'Ag et de Se, et une résine thermoplastique comme liant organique dissoute dans un solvant organique, dans laquelle le rapport pondéral de la poudre d'Ag à la poudre de Se, exprimé par la formule (1-x)Ag : xSe se situe dans la plage de 0,20 < x ≤ 0,80.

2. Composition d'encre à base d'Ag-Se selon la revendication 1, dans laquelle la résine thermoplastique est choisie parmi le polystyrène et des copolymères de polystyrène.

3. Composition d'encre à base d'Ag-Se selon la revendication 1 ou 2, dans laquelle le solvant est choisi parmi le groupe consistant en le toluène, l'éthylbenzène, le chlorobenzène, le N,N-diméthylformamide, le cyclohexanol, la cyclohexanone et leurs mélanges.

4. Composition d'encre à base d'Ag-Se selon l'une quelconque des revendications 1 à 3, dans laquelle le rapport pondéral des poudres d'Ag et de Se au poids total de la résine thermoplastique et du solvant organique se situe dans la plage allant de 0,5:1 à 2,5:1.

5. Composition d'encre à base d'Ag-Se selon l'une quelconque des revendications 1 à 4, comprenant en outre, au moins un additif choisi parmi des matériaux siliceux ou siliceux et alumineux, de préférence de la fumée de silice.

6. Composition d'encre à base d'Ag-Se selon l'une quelconque des revendications 1 à 5, dans laquelle la taille des particules de la poudre d'Ag se situe à 10,0 $\mu$m ou moins.

7. Composition d'encre à base d'Ag-Se selon l'une quelconque des revendications 1 à 6, dans laquelle la taille des particules de la poudre de Se se situe à 150 $\mu$m ou moins.

8. Procédé de production d'un matériau thermoélectrique de type n à base d'Ag-Se, flexible, imprimé, comprenant les étapes de :

   - provision de la composition d'encre à base d'Ag-Se selon l'une quelconque des revendications 1 à 7 ;
   - impression de la composition d'encre à base d'Ag-Se sur un substrat, et
   - frittage de la composition d'encre à base d'Ag-Se à une température allant de 160°C à 350°C.

9. Procédé selon la revendication 8, dans lequel l'étape de frittage est réalisée pendant au moins 60 secondes.

10. Procédé selon la revendication 8 ou 9, dans lequel l'étape d'impression de la composition d'encre à base d'Ag-Se sur le substrat est réalisée par au moins un procédé choisi parmi le groupe consistant en la sérigraphie, l'impression à la racle, l'aérographie et l'impression par jet d'encre.

11. Matériau thermoélectrique de type n à base d'Ag-Se, flexible, imprimé, pouvant être obtenu par l'impression de la composition d'encre à base d'Ag-Se selon l'une quelconque des revendications 1 à 7 sur un substrat et le frittage de la composition d'encre à base d'Ag-Se à une température allant de 160°C à 350°C, dans lequel le matériau thermoélectrique de type n imprimé comprend une phase binaire Ag$_2$Se.

12. Matériau thermoélectrique de type n à base d'Ag-Se, flexible, imprimé selon la revendication 11, ayant une épaisseur allant de 10 à 100 $\mu$m.

13. Générateur thermoélectrique flexible imprimé comprenant le matériau thermoélectrique de type n à base d'Ag-Se, flexible, imprimé selon la revendication 11 ou 12, en tant que bras de type n.

14. Générateur thermoélectrique flexible imprimé selon la revendication 13, comprenant en outre des bras de type p composé d'un polymère conducteur imprimable choisi parmi les polymères à base de poly(3,4-éthylènedioxythiophène) dopés p.

15. Utilisation du générateur thermoélectrique flexible imprimé selon la revendication 13 ou 14, dans des applications de récupération de chaleur, ou dans des applications de refroidissement intégrées à des matériaux portables, pour maintenir ou réduire la température corporelle.

Fig. 1

**Fig. 2**

**Fig. 3**

**Fig. 4**

EP 3 796 404 B1

Fig. 5

Fig. 6

**Fig. 7**

**Fig. 8**

**Fig. 9**

**Fig. 10**

**Fig. 11**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3477718 A1
- US 2019002711 A1
- CN 109585638 A

**Non-patent literature cited in the description**

- **G.H. KIM et al.** *Nat. Mater.,* 2013, vol. 12, 719-723
- *Nature Materials,* 2015, vol. 14, 622-627
- **YUFEI DING et al.** High performance n-type Ag2Se film on nylon membrane for flexible thermoelectric power generator. *NATURE COMMUNICATIONS,* 19 February 2019, vol. 10